# EUROPÄISCHE PATENTANMELDUNG

(11) **EP 2 458 950 A1**
(43) Veröffentlichungstag der Anmeldung: **30.05.2012**
(21) Anmeldenummer: 12151610.8
(22) Anmeldetag: 18.01.2012
(51) Int. Cl.: H05K 3/20, C25D 7/06

(54) **Verfahren sowie Strukturelektrode zur Herstellung einer metallischen Leiterbahnstruktur**

(71) Anmelder: ZYRUS Beteiligungsgesellschaft mbH & Co. Patente I KG, 12529 Schönefeld / Waltersdorf (DE)
(72) Erfinder: Tode, Siegfried, 20251 Hamburg (DE); Becker, Eike, 30161 Hannover (DE)
(74) Vertreter: Zech, Stefan Markus

(57) **Zusammenfassung**

Verfahren zur Herstellung einer metallischen Leiterbahnstruktur (16), umfassend die Schritte:
a. Bereitstellung einer Steuerelektrode (10), die metallische und/oder halbleitende, leitfähige Bereiche der vorgegebenen Struktur mit gegenüber den übrigen Bereichen erhöhter Leitfähigkeit hat;
b. Kontaktieren der Steuerelektrode (10) mindestens bereichsweise mit einem Elektrolyten enthaltend mindestens ein Metall und Erzeugen eines Stromflusses über die Strukturelektrode (10) durch den Elektrolyten derart, dass unmittelbar oberhalb der metallischen und/oder halbleitenden, leitfähigen Bereiche die metallische Leiterbahnstruktur (16) gebildet wird;
c. Verbinden der Leiterbahnstruktur (16) mit einem Trägermaterial (20) zu einem Verbund;
d. Entfernen des Verbunds aus Leiterbahnstruktur (16) und Trägermaterial (20) von der Strukturelektrode (10).

## Beschreibung

Die Erfindung betrifft ein Verfahren nach Anspruch 1, eine Strukturelektrode nach Anspruch 9, eine Einheit nach Anspruch 13 zur Herstellung einer metallischen Leiterbahnstruktur sowie die Verwendung der metallischen Leiterbahnstruktur nach Anspruch 14.

Für die Herstellung feinstrukturierter Leiterbahnen bzw. Leiterbahnstrukturen wird eine Vielzahl verschiedener Verfahren eingesetzt. Grundsätzlich können diese Verfahren in additive und subtraktive Verfahren eingeteilt werden.

Als subtraktiv werden Verfahren bezeichnet, in denen die Leiterbahnstruktur aus einer geschlossenen Materialschicht durch Abtragen der nicht benötigten Bereiche herauspräpariert werden. Ein Beispiel für solche subtraktiven Verfahren ist die Kombination eines Photolithographieschritts mit einer Ätzung. In dem Photolithographieschritt wird zunächst eine Materialschicht, aus der die Leiterbahn hergestellt werden soll, mit einer lichtempfindlichen zweiten Schicht bedeckt. Mittels eines Belichtungsschritts, der unter anderem eine Kontakt- oder Projektionsbelichtung oder eine rasternde oder vektoriell abfahrende Laserstrahlbelichtung sein kann, und einer nachfolgenden Entwicklung, werden die nicht für die Leiterbahnstruktur benötigten Oberflächenbereiche freigelegt, während die Bereiche der herzustellenden Leiterbahnstruktur durch die zweite Schicht bedeckt bleiben. In einer anschließenden Ätzung werden die nicht abgedeckten Bereiche der Materialschicht chemisch oder physikalisch entfernt, so dass nur noch die Leiterbahnstruktur auf einem Trägermaterial verbleibt.

Ein anderes Beispiel für ein subtraktives Verfahrens ist das so genannte "laser direct patterning" (LDP), bei dem mit Hilfe eines Laserstrahls die nicht benötigten Bereiche der ursprünglich durchgehenden Materialschicht ablativ (beispielsweise durch Verdampfen) entfernt werden. Grundsätzlich ist die Herstellung der Leiterbahnen dabei mit einem umso höheren Kostenaufwand verbunden (sowohl hinsichtlich der benötigten Vorrichtung als auch hinsichtlich der laufenden Kosten des Verfahrens), je kleiner die Strukturgrößen werden. Außerdem ist der Verbrauch des Leiterbahnmaterials durch den Abtrag der nicht benötigten Bereiche vergleichsweise hoch. Dieser Verbrauch wird bei feiner werdender Auflösung noch zusätzlich erhöht, dadurch, dass die Dicke der Leiterbahnenschicht üblicherweise verringert werden muss. Da die durchgehende Schicht des Leiterbahnmaterials in der Regel als Folie auf das Trägermaterial aufgebracht wird und derartige Folien handhabungsbedingt eine gewisse Dicke aufweisen müssen, muss für die höchstauflösenden Verfahren die Materialstärke nach dem Aufbringen und vor dem Strukturieren (meist durch Ätzprozesse) großflächig abgedünnt werden.

Im Gegensatz zu den subtraktiven Verfahren bezeichnet man als additive Verfahren solche, bei denen das Leiterbahnmaterial von vornherein nur an denjenigen Stellen des Trägermaterials aufgebracht wird, an denen eine Leiterbahnstruktur vorgesehen sein soll. Unter anderem sind in diesem Zusammenhang Verfahren bekannt, bei denen die Oberfläche des Trägermaterials (beispielsweise mittels Laserstrahl) derart modifiziert wird, dass in einer nasschemischen Materialabscheidung (so genanntes nichtgalvanisches Verdichten bzw. "electroless platin") nur in den Bereichen, in denen die Leiterbahnstruktur vorgesehen sein sollen, Material abgeschieden wird, oder dass großflächig aufgebrachtes Leiterbahnmaterial nur in den vorbestimmten Bereichen auf dem Trägermaterial haftet. Ein anderes additives Verfahren ist beispielsweise das so genannte "through mask platin", bei dem das Trägermaterial, das bei Leiterbahnen zweckmäßigerweise in aller Regel elektrisch isolierend gewählt ist, zunächst mit einer dünnen leitfähigen Schicht (so genannte Impfschicht bzw. Startschicht bzw. "seed layer") versehen wird, auf der dann photolithographisch die nicht für die Leiterbahnen vorgesehenen Bereiche mit einem isolierenden Material (beispielsweise mit einem Fotolack bzw. "photo resist") abgedeckt werden. Bei einem anschließenden galvanischen Abscheideschritt wächst dadurch nur auf den freiliegenden Bereichen des seed layers das Leiterbahnmaterial auf. Das isolierende Material kann anschließend entfernt werden und der seed layer in den Bereichen, in denen keine Leiterbahnabscheidung stattfand, beseitigt werden.

Während bei diesen additiven Verfahren das Problem des hohen Materialverbrauchs der subtraktiven Verfahren nicht mehr vorliegt, sind diese ebenfalls mit den genannten steigenden Kosten für die Strukturierung bei kleiner werdender Strukturgröße behaftet, da in allen Fällen die Strukturierung jeweils auf dem einzelnen Trägermaterial-Werkstück vorgenommen werden muss.

Aus der DE 101 40 666 A1 ist ein additives Verfahren bekannt, bei dem auf einer Strukturelektrode auf entsprechenden leitfähigen Bereichen zunächst elektrochemisch ein leitfähiges Polymer aufgewachsen wird. Auf diesem Polymer wird dann galvanisch das Leiterbahnmaterial abgeschieden. Das leitfähige Polymer zwischen der Strukturelektrode und der Leiterbahn dient dabei als Trennschicht, die das Ablösen der Leiterbahnen von der Strukturelektrode ermöglichen soll. Die Polymerschicht ist bei diesem Verfahren eine Opferschicht, die im Endprodukt in der Regel keine (elektrische, chemische oder mechanische) Funktion aufweist. Auch bei diesem Verfahren ist somit der Materialaufwand noch vergleichsweise hoch, was zu vergleichsweise hohen Kosten führt. Das Entfernen des Polymers von der Leiterbahn ist ebenfalls vergleichsweise aufwändig und verursacht Kosten.

Es ist daher Aufgabe der vorliegenden Erfindung, ein Verfahren und eine Strukturelektrode zur Herstellung metallischer Leiterbahnstrukturen aufzuzeigen, bei denen Herstellungsaufwand und Kosten reduziert sind.

Diese Aufgabe wird durch ein Verfahren nach Anspruch 1, eine Strukturelektrode nach Anspruch 9, eine Einheit nach Anspruch 13 zur Herstellung einer metallischen Leiterbahnstruktur sowie die Verwendung der metallischen Leiterbahnstruktur nach Anspruch 14 gelöst.

Insbesondere wird die Aufgabe durch ein Verfahren zur Herstellung einer metallischen Leiterbahnstruktur mit folgenden Schritten gelöst:
a) Bereitstellung einer Strukturelektrode, die metallische und/oder halbleitende, leitfähige Bereiche einer vorgegebenen Struktur mit gegenüber den übrigen Bereichen erhöhter Leitfähigkeit hat;
b) Kontaktieren der Strukturelektrode mindestens bereichsweise mit einem Elektrolyten enthaltend mindestens ein Metall und Erzeugen eines Stromflusses über die Strukturelektrode durch den Elektrolyten derart, dass unmittelbar oberhalb der metallischen und/oder halbleitenden, leitfähigen Bereiche die metallische Leiterbahnstruktur gebildet wird;
c) Verbinden der Leiterbahnstruktur mit einem Trägermaterial zu einem Verbund; und
d) Entfernen des Verbundes aus strukturierter Metallschicht und Trägermaterial von der Strukturelektrode.

Ein Kerngedanke der Erfindung besteht darin, dass die strukturierte Metallschicht unmittelbar auf die leitfähigen Bereiche der Strukturelektrode durch Galvanisieren aufgebracht wird. Es ist somit keine Zwischenschicht, wie beispielsweise eine Polymerschicht analog DE 101 40 666 A1, vorgesehen. Bisher ist man im Stand der Technik, was insbesondere durch die eben genannte Druckschrift dokumentiert ist, davon ausgegangen, dass derartige Metallschichten, zumindest wenn sie hochauflösend strukturiert sind, nicht ohne diese zu zerstören von der Elektrode entfernt werden können. Es konnte jedoch überraschenderweise festgestellt werden, dass (falls gewisse Randbedingungen erfüllt sind) ein Entfernen einer derartig gebildeten Leiterbahnstruktur von der Strukturelektrode im Ganzen möglich ist.

Der wesentliche Vorteil besteht gegenüber den subtraktiven Verfahren in einer erheblichen Einsparung des Leiterbahnmaterials. Gegenüber sowohl den subtraktiven als auch den bekannten additiven Verfahren können die Kosten für die Strukturierung, insbesondere bei hohen (lateralen) Auflösungen verringert werden. Gegenüber der DE 101 40 666 A1 wird das Verfahren durch das Auslassen des Polymerabscheideprozesses deutlich vereinfacht und verkürzt, die Verfahrenskosten können durch Einsparung der Polymerisationschemikalien weiter gesenkt werden, und der Raum der Galvanik-Parameter für die Abscheidung des Leiterbahnmaterials kann signifikant erhöht werden, da die physikalischen und chemischen Randbedingungen, die die Anwesenheit des Polymers an die Elektrolyten und die Strukturelektrode angelegten Potentiale stellen, wegfallen.

Die Strukturelektrode, die in Form von leitfähigen und nicht-leitfähigen (bzw. weniger leitfähigen) Oberflächenbereichen die herzustellende Leiterbahnstruktur aufweist, kann vorzugsweise wiederverwendbar ausgelegt sein, so dass die Herstellungskosten für die Strukturierung der Strukturelektrode nur einmalig anfallen. Mit derselben Strukturelektrode können dann mehrere Leiterbahnstrukturen bzw. Trägermaterialien mit einer Leiterbahnstruktur hergestellt werden.

Das Material der Leiterbahnstruktur kann mit dem Trägermaterial (beispielsweise durch Laminieren oder Kleben) verbunden werden und mit diesem von der Strukturelektrode abgezogen werden. Anschließend kann die Leiterbahnstruktur von dem Trägermaterial entfernt werden oder auf diesem verbleiben.

Vorzugsweise wird zumindest die Oberfläche der leitfähigen Bereiche derart ausgebildet, insbesondere physikalisch und/oder chemisch behandelt, und/oder das die Leiterbahnstruktur ausbildende Metall derart ausgewählt und/oder das Material der Strukturelektrode derart ausgewählt, dass die strukturierte Metallschicht im Schritt d) von der Strukturelektrode entfernt werden kann, jedoch im Schritt b) (während des Galvanisierungsprozesses) an der Strukturelektrode verbleibt (sich also nicht ablöst).

Insgesamt wird die Herstellung durch die beschriebenen Maßnahmen vereinfacht. Das Ablösen der Leiterbahnstruktur im Ganzen kann auf vergleichsweise einfache Art und Weise durchgeführt werden.

Weiter vorzugsweise ist die Strukturelektrode zumindest teilweise aus Stahl oder einem anderen Metall oder einer anderen metallisch leitfähigen Verbindung, insbesondere aus Edelstahl, und/oder zumindest bereichsweise poliert, insbesondere spiegelpoliert. Dadurch wird das Ablösen der strukturierten Metallschicht von der Strukturelektrode vereinfacht, was die Herstellungskosten reduziert.

Eine Oberflächenrauheit der Strukturelektrode ist vorzugsweise im Mittel kleiner als 5µm, vorzugsweise kleiner als 1µm, vorzugsweise kleiner als 500nm, weiter vorzugsweise kleiner als 200nm, noch weiter vorzugsweise kleiner als 100nm, noch weiter vorzugsweise kleiner als 50nm, weiter vorzugsweise kleiner als 10nm. Auch dadurch wird das Herstellungsverfahren vergleichsweise einfach, da insbesondere ein Ablösen der Leiterbahnstruktur mit vergleichsweise wenig Komplikationen verbunden ist.

Vorzugsweise umfasst die Strukturelektrode eine, insbesondere strukturierte, elektrisch isolierende Isolierungsschicht. Eine derartig ausgestaltete Strukturelektrode ist besonders einfach in der Herstellung.

In einer bevorzugten Ausgestaltung ist eine Schichtdicke der Leiterbahnstruktur größer als eine Isolierungsschichtdicke der Isolierungsschicht, insbesondere mindestens 1,2mal, vorzugsweise wenigstens 1,5mal, noch weiter vorzugsweise mindestens 2mal so groß. Auch eine derartige Maßnahme vereinfacht das Ablösen der Leiterbahnstruktur.

In konkreten Ausführungsformen wird das Trägermaterial in festem oder flüssigem Zustand, insbesondere in einem Rolle-zu-Rolle-Verfahren auf die Strukturelektrode bzw. die Leiterbahnstruktur aufgebracht. Dadurch kann das Herstellungsverfahren weiter vereinfacht werden, was Kosten senkt.

In einer konkreten Weiterbildung wird die Leiterbahnstruktur nach dem Transfer auf das erste Trägermaterial von diesem auf ein zweites Trägermaterial transferiert. Dadurch wird das Verfahren vergleichsweise flexibel. Insbesondere sind die Beschränkungen für das zweite Trägermaterial vergleichsweise gering.

Die oben genannte Aufgabe wird unabhängig gelöst durch eine Strukturelektrode zur Herstellung einer metallischen Leiterbahnstruktur, die metallische, leitfähige Bereiche einer vorgegebenen Struktur mit gegenüber den übrigen Bereichen erhöhter Leitfähigkeit aufweist, wobei eine Oberfläche der Strukturelektrode derart physikalisch und/oder chemisch behandelt ist, vorzugsweise poliert ist, weiter vorzugsweise spiegelpoliert ist, dass die auf die Strukturelektrode durch Galvanisieren abgeschiedene Leiterbahnstruktur im Ganzen von der Strukturelektrode entfernt werden kann. Mit einer derartigen Strukturelektrode können mit vergleichsweise geringem Aufwand äußerst feine Leiterbahnstrukturenhergestellt werden. Auflösungen von weniger als 200 µm bzw. weniger als 100 µm bzw. sogar weniger als 20 µm, bis zu 5 µm sind erreichbar.

Die Strukturelektrode ist vorzugsweise zumindest teilweise aus Stahl oder einem anderen Metall oder einer anderen metallisch leitfähigen Verbindung, insbesondere aus Edelstahl gebildet. Eine Oberflächenrauheit kann kleiner 5µm, vorzugsweise kleiner 1µm, vorzugsweise kleiner 500nm, weiter vorzugsweise kleiner 200nm, noch weiter vorzugsweise kleiner 100nm, noch weiter vorzugsweise kleiner 50nm, weiter vorzugsweise kleiner 10nm sein.

Die Strukturelektrode ist vorzugsweise für ein Verfahren der vorbeschriebenen Art ausgebildet bzw. kommt in diesen zum Einsatz.

Die oben genannte Aufgabe wird weiterhin unabhängig gelöst durch eine Einheit aus einer Strukturelektrode insbesondere der vorbeschriebenen Art und einem Elektrolyten mit mindestens einem Metall zur Herstellung einer metallischen Leiterbahnstruktur, vorzugsweise für das Verfahren der vorbeschriebenen Art, wobei eine Oberfläche der Strukturelektrode und die Zusammensetzung des Elektrolyten derart aufeinander abgestimmt sind, dass bei einem Abscheiden des Elektrolyten als Leiterbahnstruktur auf die Oberfläche der Strukturelektrode, diese im Ganzen von der Strukturelektrode entfernt werden kann. Hinsichtlich der Vorteile wird auf die oben beschriebene Strukturelektrode bzw. das Verfahren zur Herstellung von metallischen Leiterbahnstrukturen verwiesen.

Die oben genannte Aufgabe wird weiterhin gelöst durch die Verwendung der metallischen Leiterbahnstruktur, hergestellt in dem Verfahren der weiter oben beschriebenen Art und/oder mit der Strukturelektrode der vorbeschriebenen Art und/oder der Einheit der vorbeschriebenen Art, zur Verbindung von Kontaktpunkten oder -bereichen von elektrischen oder elektronischen Bauteilen miteinander und/oder mit den Kontaktpunkten oder -bereichen anderer Bauteile und/oder als elektrische oder elektronische Bauteile und/oder als Bestandteile von diesen, insbesondere als Leiterplatte oder als Bestandteil von Leiterplatten, als Substrat oder Hilfssubstrat für die Verkapselung bzw. Kontaktierung von elektronischen Bauteilen, wie beispielsweise Mikrochips, als passives elektronisches Bauteil, wie beispielsweise als Antenne, Spule, Widerstand oder Elektrode eines Kondensators oder als Kombination dieser Bauteile, als Zwischenträger für den Transfer von Leiterbahnen auf andere Werkstücke und/oder als Kontaktierungslager für Solarzellen und/oder großflächige Leuchtsysteme und/oder ähnliche Bauteile.

Das Leiterbahnmaterial lässt sich vorzugsweise zwar ohne Selbstablösung galvanisch abscheiden, haftet auf der Strukturelektrode jedoch nur so gering, dass es sich auch ohne eine Polymer-Trennschicht von der Elektrodenoberfläche ablösen und auf ein Trägermaterial transferieren lässt. Die dafür benötigte Haftungseigenschaft kann entweder materialbedingt seitens der Elektrode, seitens des Leiterbahnmaterials oder seitens einer Kombination beider Materialien gegeben sein und/oder durch eine physikalische oder chemische Oberflächenbehandlung der Strukturelektrode herbeigeführt werden.

Ein Grundmaterial zur Herstellung der Strukturelektrode muss elektrisch leitfähig sein und kann beispielsweise aus einem ausreichend hoch dotierten Halbleitermaterial oder einem Metall oder einer metallischen Legierung bestehen, oder aus einem Werkstück, auf dem sich ein ausreichend hoch dotiertes Halbmaterial oder ein Metall oder eine metallische Legierung befindet. Eine physikalische und/oder chemische Vorbehandlung kann gegebenenfalls mehrschrittig erfolgen, was für die aufzubringenden strukturierten Metallschichten zu einer geeignet eingestellten Haftung auf der Strukturelektrode führen kann.

Auf dem Grundmaterial bzw. einem Grundmaterial-Werkstück kann eine elektrisch isolierende Isolierungsschicht aufgebracht werden. Beispielsweise kann es sich dabei um eine Siliziumoxidschicht, eine Siliziumnitridschicht oder eine Siliziumoxynitridschicht handeln, oder auch um eine Aluminiumoxidschicht oder Aluminiumhydroxidschicht oder eine Carbonschicht oder diamantartige Carbonschicht handeln oder um eine mehrschichtige Anordnung dieser oder ähnlicher Materlialien, die beispielsweise mit einem Spin-On und/oder Sol-Gel- und/oder PVD- und/oder CVD- und/oder PECVD-und/oder HDP- und/oder ALD-Verfahren auf dem Grundmaterial abgeschieden werden.

Gegebenenfalls wird vor dem Auftragen der Isolierungsschicht oder einem isolierenden Schichtsystem eine elektrisch leitfähige Zwischenschicht auf dem Grundmaterial aufgebracht, beispielsweise zur Verbesserung der Haftung zwischen Grundmaterial und Isolierungsschicht. Gegebenenfalls können in oder auf einer derartigen Isolierungsschicht-Anordnung auch nichtisolierende Lagen enthalten sein, sofern diese keinen oder nur einen hochohmigen elektrischen Kontakt zu einer Grundmaterialoberfläche besitzen.

Die Isolierungsschicht kann strukturiert werden, wobei beispielsweise die Kombination eines Photolithographieschrittes mit einem Ätzprozess eingesetzt werden kann. Eine bevorzugte Verfahrensabfolge besteht beispielsweise aus der Beschichtung der Isolierungsschicht auf dem Grundmaterial mit einem photosensitiven Material, der örtlichen Belichtung dieses Materials mittels beispielsweise Kontakt- oder Projektionsbelichtung und/oder mittels rasterndem oder vektoriell abfahrendem Laserstrahl, einem Entwicklungsschritt zum Abtrag des belichteten oder des unbelichteten Bereichs der photosensitiven Schicht und einem gegebenenfalls mehrere Schritte umfassenden, nasschemischen, trockenchemischen und/oder physikalischen Ätzprozess oder einer Kombination davon zum Abtrag derjenigen Bereiche der Isolierungsschicht bzw. des isolierenden Schichtsystems (und gegebenenfalls vorhandener nichtisolierender Zwischenschichten), die nicht von den verbliebenen Teilen der photosensitiven Schicht abgedeckt sind.

Beispielsweise kann die Strukturelektrode, insbesondere eine spiegelpolierte Edelstahlelektrode, mit einer Aluminiumoxidschicht überzogen werden, auf der vorzugsweise mittels üblicher Photolithographietechniken definierte Gebiete z.B. mit einem Diazonaphtoquinon-Novolak-basierten Positiv-Photoresist abgedeckt sind. Die durch die Abdeckung vorgegebene Struktur wird dann beispielsweise mit einer insbesondere nasschemischen Ätzung mit vorzugsweise gepufferter Flusssäure und/oder einer Phosphorsäure-Salpetersäure-Essigsäure-Mischung in die Aluminiumoxidschicht übertragen.

Zur Strukturierung der Isolierungsschicht kommen jedoch auch andere Verfahren in Frage, wie beispielsweise ablative Techniken analog des laser direct patterning. Die isolierende Schicht kann auch von vornherein nur in den Bereichen aufgebracht werden, in denen später keine Leiterbahnstrukturen erzeugt werden sollen.

Nach der Strukturierung der isolierenden Schicht kann wiederum eine physikalische und/oder chemische, gegebenenfalls auch mehrschrittige, Vorbehandlung der Strukturelektrode durchgeführt werden. Beispielsweise kann es sich dabei um eine chemische Beschichtung der Bereiche mit erhöhter Leitfähigkeit und/oder Bereiche mit niedriger Leitfähigkeit (der isolierenden Bereiche) der Elektrode mit einem die Haftung galvanisch abgeschiedener Schichten oder anderer prozessrelevanter Materialien beeinflussenden Material oder mit entsprechenden Funktionsgruppen handeln. Diese kann beispielsweise durch Kontakt der Elektrode mit reaktiven Dämpfen oder reaktiven Flüssigkeiten erfolgen, beispielsweise durch Eintauchen der Elektrode in eine Flüssigkeit, die eine z.B. fluorhaltige Antihaftbeschichtung auf den Bereichen erhöhter Leitfähigkeit hinterlässt, wie beispielsweise eine Lösung von 3,3,4,4,5,5,6,6,7,7,8,8,8-Tridecafluoro-1-octanthiol in Isopropanol, oder durch Eintauchen in eine Flüssigkeit, die z.B. Fluorosilangruppen auf der Oberfläche der verbliebenen isolierenden Bereiche hinterlassen kann, wie beispielsweise eine Lösung von Trichloro-(1H, 1H, 2H, 2H-Perfluorooctyl)-Silan in Toluol. Alternativ oder zusätzlich (davor oder danach) kann auch eine physikalische Beschichtung von Teilen der Elektrode vorgenommen werden. Insbesondere können freigelegte Grundmaterialbereiche mit einem zusätzlichen Stoff, beispielsweise Metall, beschichtet werden, z.B. indem (gegebenenfalls nach der oben beschriebenen nasschemischen Ätzung der Isolierungsschicht) der gewünschte Stoff ohne vorheriges Entfernen des Photoresists auf die Strukturelektrode aufgedampft wird. Anschließend kann dabei (durch nasschemisches Entfernen des Photoresists bzw. "lift off") der aufgedampfte Stoff überall dort entfernt werden, wo die isolierende Schicht nicht geätzt wurde.

Bedarfsweise kann eine gegebenenfalls auf dem Grundmaterial der Strukturelektrode unter der Isolierungsschicht aufgebrachte elektrisch leitfähige Schicht nach der Strukturierung der Isolierungsschicht in den freigelegten Bereichen ganz oder teilweise entfernt werden.

Mittels einer Kombination der genannten physikalischen bzw. chemischen Oberflächenmodifikationen des Grundmaterials der Strukturelektrode kann die Haftung des galvanisch abzuscheidenden Leiterbahnmaterials auf den leitfähigen Bereichen der Strukturelektrode so eingestellt werden, dass einerseits eine galvanische Beschichtung ohne Selbstablösung der Schicht während des Abscheideprozesses möglich ist, und dass andererseits ein Transfer der Leiterbahnstrukturen auf das Ziel-Trägermaterial ohne ein Zwischensubstrat möglich ist.

Auf den leitfähigen Bereichen der Strukturelektrode kann - ggf. nach Reinigungs-und/oder Trocknungs- und/oder Vorbehandlungsschritten gemäß dem Stand der Technik - galvanisch das Leiterbahnmaterial abgeschieden werden.

Bei dem Leiterbahnmaterial kann es sich um ein Metall, eine metallische Legierung, ein Eutektikum, ein anderes leitfähiges Material oder eine Schichtstruktur aus nacheinander abgeschiedenen Einzelschichten von einem oder mehreren Materialien der eben genannten oder ähnlichen Materialklassen handeln. Vorzugsweise können als Leiterbahnmaterial oder Einzelschichten eines mehrschichtigen Leiterbahnmaterials beispielsweise Nickel, Chrom, Gold, Silber, Platin, Indium, Zinnsilber bzw. Zinnsilberkupfer und besonders bevorzugt Kupfer zum Einsatz kommen. Insbesondere kann das Leiterbahnmaterial auch aus einem 2- oder mehrschichtigen Aufbau bestehen, in dem das zuerst abgeschiedene Material (beispielsweise Kupfer) die Ablösbarkeit von der Strukturelektrode gewährleistet.

Der Transfer der Leiterbahnstruktur von der Strukturelektrode kann direkt auf ein Trägermaterial für eine spätere Anwendung erfolgen oder auch zunächst auf ein Zwischenträgermaterial, von dem aus ein zweiter Transfer stattfinden kann.

Der Transfer findet vorzugsweise statt, indem nach abgeschlossenem Galvanikprozess (und ggf. nötigem Reinigungs- und/oder Trocknungsschritten) die Strukturelektrode mit dem Trägermaterial (oder dem Zwischenträgermaterial) mechanisch in Kontakt gebracht wird. Bevorzugte Trägermaterialien sind insbesondere Folien, vorzugsweise Polyimid oder (epoxidgetränkte) Gewebe oder (epoxidgetränktes oder -ungetränktes) Papier, PVC oder PET, die ggf. mit Acrylat-, Epoxyd-, UV-, Hotmelt- oder anderen Klebeschichten versehen sind. Besonders bevorzugte Trägermaterialien sind acrylat- oder epoxidbeschichtete Folien, insbesondere Polyimidfolien oder FR4-getränkte Glasfasergewebe.

Auf mechanischem, thermischem, photochemischem oder chemischem Weg (oder einer Kumulation davon) kann während des Kontaktes eine Verbindung zwischen den Leiterbahnstrukturen und dem Trägermaterial (bzw. dem Zwischenträgermaterial) hergestellt werden. Dann kann das Trägermaterial von der Strukturelektrode abgezogen werden, wobei die Leiterbahnstruktur von der Elektrode abgelöst wird und im Verbund mit dem Trägermaterial verbleibt. Alternativ kann das Trägermaterial aber auch aus flüssig aufgebrachtem Material, wie beispielsweise Spin-On-Materialien (wie beispielsweise Polyimid) oder einem anderen auf der Strukturelektrode erzeugten oder verfestigten Stoff bestehen. In diesem Fall kann die Haftung der Leiterbahnstrukturen am Trägermaterial während dessen Verfestigung erfolgen.

Das Trägermaterial kann anschließend zusammen mit den Leiterbahnstrukturen Reinigungen oder anderen Nachbehandlungen unterzogen werden.

Die Strukturelektrode kann nach dem Ablösen der Metallschicht einer (mehrschrittigen) Reinigung und/oder Vorbehandlung unterzogen werden. Insbesondere kann eine Entfernung von Resten des Leiterbahnmaterials wünschenswert sein, wie beispielsweise durch ein nasschemisches Abätzen von Metallresten (Kupferresten) mit einer Eisen (III) Chlorid-Lösung und/oder eine erneute physikalische oder chemische Oberflächenbehandlung zur Auffrischung der Haftungseigenschaften. Danach kann die Strukturelektrode erneut dem oben beschriebenen Verfahren (Galvanik- und Transferprozess) unterzogen werden.

Besonders bevorzugt kann die Strukturelektrode mehrfach innerhalb eines kontinuierlichen Prozesses zum Einsatz kommen. Insbesondere kann das Trägermaterial in Bandform im Rahmen eines Rolle-zu-Rolle-Prozesses zugeführt werden. Derartige Maßnahmen vereinfachen das Verfahren und fördern insbesondere einen automatischen Ablauf.

Die erfindungsgemäß hergestellten Leiterbahnstrukturen mit entsprechenden Trägersubstraten können insbesondere zur definierten Verbindung von Kontaktpunkten von elektrischen oder elektronischen Bauteilen miteinander oder mit den Kontaktpunkten anderer Bauteile oder direkt als elektrisches oder elektronisches Funktionselement oder Teil eines solchen Funktionselementes verwendet werden. Dies kann unter Beibehaltung der Verbindung zwischen dem Trägersubstrat und den Leiterbahnstrukturen oder unter Lösung dieser Verbindung erfolgen, ggf. unter Herstellung einer weiteren Verbindung zwischen den Leiterbahnstrukturen und/oder dem Trägersubstrat und den Bauteilen und/oder einem zweiten Trägersubstrat, auf dem sich die Bauteile befinden.

Zu verbindende Bauteile in diesem Sinne können beispielsweise (diskrete) elektronische Bauteile, wie Widerstände, Spulen, Kondensatoren, Transistoren oder dergleichen sein, integrierte Schaltungen wie Mikrochips in verkapselter oder unverkapselter Form, Solarzellen, Beleuchtungsquellen, wie LEDs oder OLEDs, Anzeigeeinrichtungen, wie LCDs, Sensoren und Messeinrichtungen aller Art, Strom- oder Spannungsquellen oder Stromspeicher wie Akkumulatoren. Funktionselemente können unter anderem Widerstände, Spulen, Antennen oder elektrisch, magnetisch oder optisch auslesbare Identifikationselemente sein. Teile von Funktionselementen können beispielsweise Anschlüsse bzw. Metallisierungen sein oder die Elektroden von Kondensatorstrukturen.

Wenn von einer "Schicht", insbesondere "Isolierungsschicht" oder "Metallschicht" die Rede ist, so kann diese durchgehend oder unterbrochen sein, insbesondere aus mehreren voneinander getrennten Teilschichten bestehen.

Die Leitfähigkeit der Bereiche mit erhöhter Leitfähigkeit kann beispielsweise mindestens 2fach, weiter vorzugsweise mindestens 10fach, insbesondere mindestens 100fach bezüglich der Leitfähigkeit der übrigen Bereiche sein. Die Leitfähigkeit der Bereiche mit erhöhter Leitfähigkeit kann beispielsweise im Mittel mindestens 1 S/m oder auch mindestens 10 S/m, 100 S/m, 1000 S/m, 10000 S/m, 100000 S/m, 1000000 S/m oder 10000000 S/m betragen. Die übrigen Bereiche sind hinsichtlich ihrer Leitfähigkeit abhängig von den angegeben Werten jeweils geringer.

Weitere Ausführungsformen ergeben sich aus den Unteransprüchen.

Nachfolgend wird die Erfindung auch hinsichtlich weiterer Merkmale und Vorteile anhand von Ausführungsbeispielen beschrieben, die anhand der Abbildungen näher erläutert werden.

Hierbei zeigen:
Fig. 1 Eine schematische Darstellung einer Strukturelektrode;
Fig. 2a-c eine schematische Darstellung der Herstellung einer Leiterbahnstruktur;
Fig. 3 die schematische Darstellung einer ersten Ausführungsform einer Leiterplatte mit Leiterbahnstruktur;
Fig. 4 eine schematische Darstellung einer zweiten Ausführungsform einer Leiterplatte;
Fig. 5 eine schematische Darstellung einer dritten Ausführungsform einer Leiterplatte;
Fig. 6 eine schematische Darstellung einer vierten Ausführungsform einer Leiterplatte;
Fig. 7a-7j eine schematische Darstellung eines Verfahrens zur Herstellung einer fünften Ausführungsform einer Leiterplatte sowie ihrer Verbindung mit einem mikroelektronischen Bauteil;
Fig. 8 eine schematische Darstellung einer sechsten Ausführungsform einer Leiterplatte und ihrer Verbindung mit einem mikroelektronischen Bauteil;
Fig. 9 eine schematische Ausführung einer siebten Ausführungsform einer Leiterplatte in Verbindung mit mehreren mikroelektronischen Bauteilen;
Fig. 10a - 10d eine schematische Darstellung einer achten Ausführungsform einer Leiterplatte mit eingebettetem mikroelektronischen Bauteil;
Fig. 11 eine schematische Darstellung eines Folienkondensators; und
Fig. 12 eine schematische Darstellung einer Transferfolie zum Aufbringen einer Leiterbahnstruktur.

In der nachfolgenden Beschreibung werden für gleiche und gleich wirkende Teile dieselben Bezugsziffern verwendet.

Unter Leiterplatte" soll im allgemeinen ein Bauteil mit mindestens einem Trägermaterial und mindestens einer Leiterbahnstruktur verstanden werden.

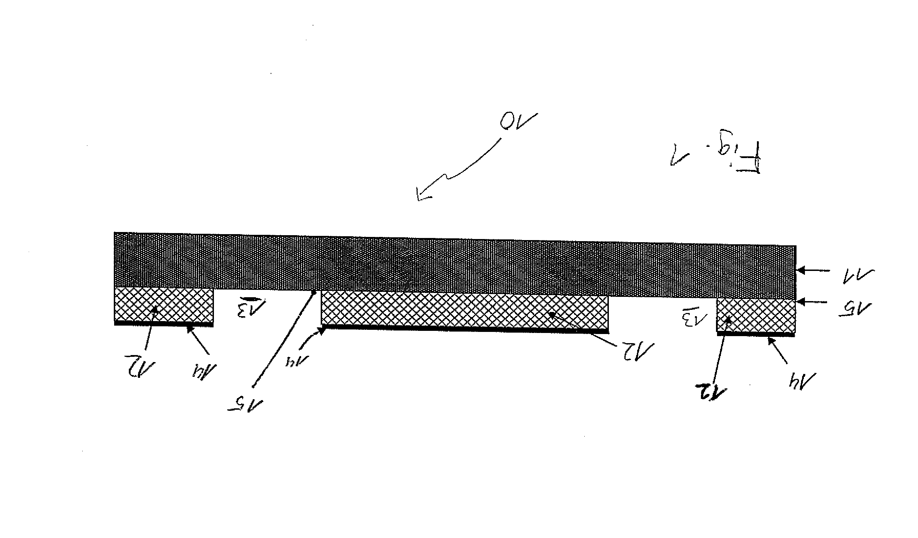

Fig. 1 zeigt eine schematische Darstellung einer Strukturelektrode 10. Diese umfasst einen Grundkörper 11, der vorzugsweise als insbesondere spiegelpoliertes Edelstahlblech oder -band ausgebildet ist. Auf dem Grundkörper 11 ist eine strukturierte Isolierungsschicht 12 aufgebracht, die vorzugsweise als Aluminiumoxidschicht ausgebildet ist. Die Isolierungsschicht 12 weist Isolierungsschichtausnehmungen 13 auf, die die Geometrie der herzustellenden Leiterbahnstrukturen vorbestimmen. Auf einer dem Grundkörper 11 abgewandten Fläche weist die Isolierungsschicht 12 eine Antihaftbeschichtung 14, vorzugsweise mit Fluorosilangruppen auf.

Die Strukturelektrode gemäß Fig. 1 kann wie folgt hergestellt werden. Zunächst kann als Grundkörper 11 der Strukturelektrode 10 ein spiegelpoliertes Edelstahlblech verwendet werden. Die Spiegelpolierung stellt hier eine physikalische Oberflächenmodifikation dar, durch die die Haftung des aufzubringenden Leiterbahnmaterials auf der Strukturelektrode 10 reduziert wird. Auf dem Grundkörper 11 wird eine Schicht von vorzugsweise 100 bis 500, insbesondere etwa 200 nm Aluminiumoxid beispielsweise mittels eines CVD-Verfahrens abgeschieden, das dann, ggf. nach einer Vorbehandlung mit einem Dehydrationsvorgang ("dehydration bake") und/oder einer HMDS-Grundierung ("HMDS-priming"), mit einem Positiv-Photoresist, wie beispielsweise dem AZ1512HS belackt wird. Der Fotolack ("Photoresist") wird vorgebacken ("pre bake"), mit dem Spiegelbild der gewünschten Leiterbahnstruktur belichtet und anschließend entwickelt, wodurch die Gebiete der zukünftigen Leiterbahnstruktur freigelegt werden. Zur Optimierung der Haftung und Ätzbeständigkeit des Photoresists wird ein weiterer Heizvorgang (so genannter "post bake") durchgeführt. Mittels Nassätzen in gepufferter Flusssäure (BHF) wird in den freigelegten Bereichen anschließend die Isolierungsschicht 12 entfernt, bis eine Grundkörperoberfläche 15 freiliegt. Nach Entfernen des Fotolacks mit einem Lösungsmittel und Trocknung der Strukturelektrode 10 folgt eine Beschichtung mit der Antihaftbeschichtung 14 der verbliebenen Isolierungsschicht 12 durch Eintauchen in eine reaktive Flüssigkeit, die z.B. Fluorosilangruppen auf der Oberfläche der Isolierungsschicht 12 hinterlassen kann (wie beispielsweise eine Lösung von Trichloro-(1H, 1H, 2H, 2H-Perfluorooctyl)-Silan in Toluol).

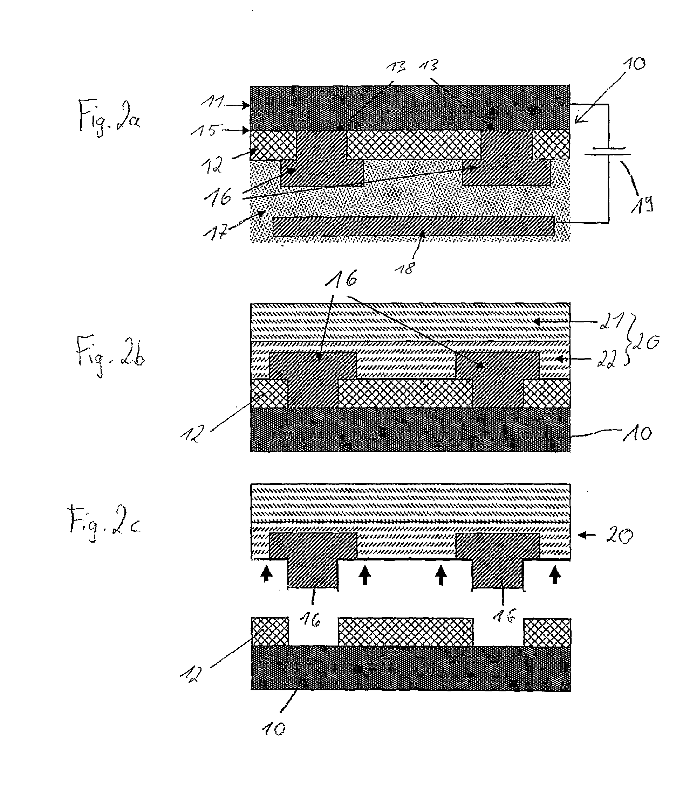

Die Fig. 2a bis 2c zeigen schematisch die Herstellung einer Leiterbahnstruktur 16.

Die Strukturelektrode 10 wird vorzugsweise als Kathode in ein Elektrolytbad 17 (insbesondere Kupferelektrolytbad) eingetaucht. Zwischen der Strukturelektrode 10 und einer Gegenelektrode 18 (Anode, insbesondere Kupferanode) wird eine Spannung 19 angelegt, so dass in den Isolierungsschichtausnehmungen 13, die nicht von der Isolierungsschicht 12 abgedeckt sind, die Leiterbahnstruktur 16 (insbesondere Kupferleiterbahnstruktur) abgeschieden wird. Eine Dicke der Leiterbahnstruktur 16 ist größer (z.B. etwa 2mal so groß oder etwa 10mal so groß) wie eine Dicke der Isolierungsschicht 12 (siehe Fig. 2a).

Gemäß Fig. 2b wird die Strukturelektrode 10 einschließlich Leiterbahnstruktur 16 derart mit einem Trägermaterial 20 verbunden (verpresst), dass die Leiterbahnstruktur 16 zwischen der Strukturelektrode 10 und dem Trägermaterial 20 liegt.

Das Trägermaterial 20 kann beispielsweise eine Trägermaterialfolie 21 (insbesondere Polyimidfolie) vorzugsweise mit einer Trägermaterialfolienbeschichtung 22 (insbesondere Acrylatbeschichtung) umfassen. Die Trägermaterialfolienbeschichtung 22 ist zwischen der Trägermaterialfolie 21 und der Strukturelektrode 10 bzw. der Leiterbahnstruktur 16 angeordnet. Im Falle einer Acrylatbeschichtung kann das Acrylat beispielsweise durch Temperatur- und Druckeinwirkung ausgehärtet werden. Dabei können die Leiterbahnstrukturen 16 in das Trägermaterial 20, insbesondere das Acrylat eingebettet werden. An Stelle einer Acrylatbeschichtung ist auch eine Epoxidbeschichtung denkbar. Das Trägermaterial 20 kann auch als FR4-Epoxidglasfasergewebelage auf die Strukturelektrode 10 auflaminiert werden, beispielsweise indem diese auf die Strukturelektrode 10 gepresst und das Epoxid durch eine Kombination von Druck und erhöhter Temperatur zunächst verflüssigt und dann mit einer anschließenden Abkühlung ausgehärtet wird. Dabei werden die über die Isolierungsschicht 12 überstehenden Teile der Leiterbahnstruktur 16 in das Epoxid bzw. Acrylat eingebettet und man erhält nach Abziehen des Trägermaterials 20 die Leiterbahnstruktur 16 zusammen mit dem Trägermaterial 20, insbesondere als Verbund.

Gemäß Fig. 2c wird das Trägermaterial 20 mit der Leiterbahnstruktur 16 mechanisch von der Strukturelektrode 10 getrennt.

Nach einer Reinigung der Strukturelektrode 10 beispielsweise mit einer Eisen-(III)-Chlorit-Lösung und bedarfsweise anschließender Neuabscheidung von Fluorosilangruppen auf der Isolierungsschicht (Aluminiumoxidschicht) 12 wird die Strukturelektrode 10 zur Herstellung eines oder mehrerer weiterer Exemplare der Leiterbahnstruktur 16 verwendet (beginnend mit Fig. 2a).

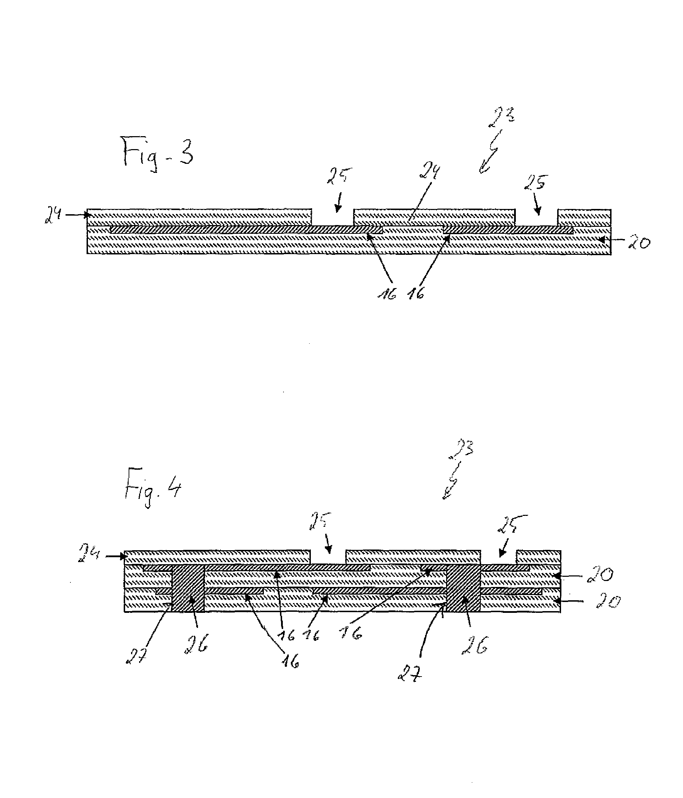

Fig. 3 zeigt schematisch eine erste Ausführungsform einer Leiterplatte 23 mit dem Trägermaterial 20, in das die Leiterbahnstruktur 16 eingebettet ist. An der Fläche des Trägermaterials 20, an dem die Leiterbahnstruktur 16 eingebettet ist, ist eine strukturierte Folie 24 angeordnet, die Folienausnehmungen 25 aufweist, beispielsweise für eine Kontaktierung. Die Folie 24 dient beispielsweise der Verkapselung und als Lötstopp.

Die Leiterplatte 23 gemäß Fig. 3 ist, insbesondere wenn das Trägermaterial 20 ebenfalls als Folie vorliegt, insgesamt sehr flexibel und daher vielseitig einsetzbar und robust.

Fig. 4 zeigt eine schematische Darstellung einer zweiten Ausführungsform einer Leiterplatte 23, die im vorliegenden Fall mehrlagig ausgebildet ist. Es sind zwei Lagen von je einem Trägermaterial (Polyimid-Folie) 20 mit eingebetteter Leiterbahnstruktur 16 übereinander angeordnet. Anschließend ist wieder eine Folie 24 als Verkapselung und Lötstopp vorgesehen. Mit einem Leitermaterial 26 gefüllte Kontaktlöcher 27 sind nachträglich, die beiden Schichten aus Trägermaterials 20 und entsprechender Leiterbahnstruktur 16 durchdringend, vorgesehen. Die mit dem Leitermaterial 26 gefüllten Kontaktlöcher bilden dabei eine Kontaktierung zwischen den Leiterbahnstrukturen 16 der beiden Schichten des Trägermaterials 20 aus.

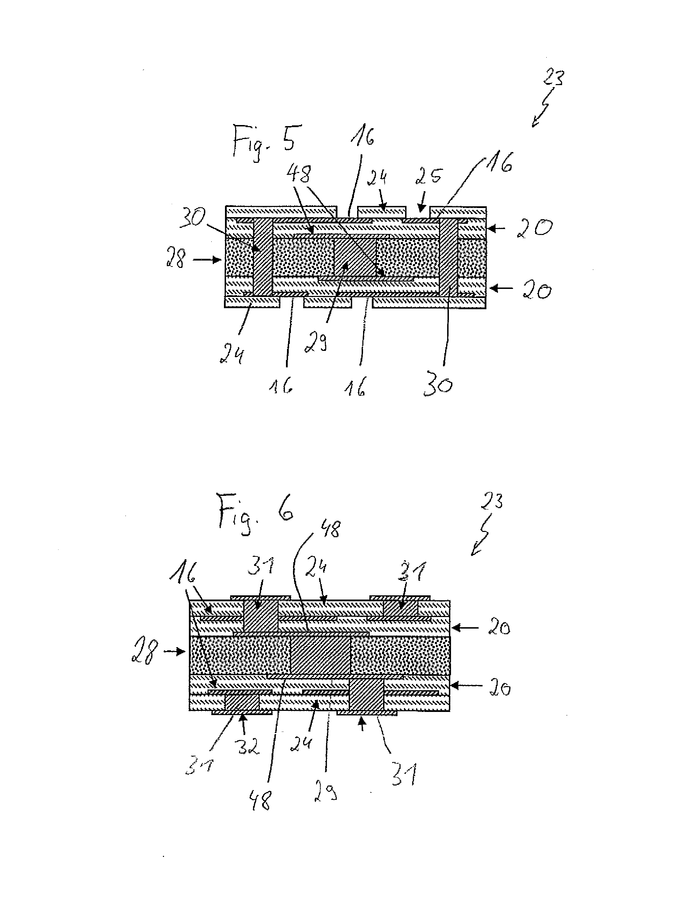

Die Fig. 5 und 6 zeigen schematische Darstellungen einer dritten sowie einer vierten Ausführungsform einer Leiterplatte 23, wobei die Leiterplatten 23 auch hier mehrlagig ausgebildet sind.

Bei den Ausführungsformen gemäß Fig. 5 und 6 ist im Zentrum ein starrer Leiterplattenkern 28 (FR4-Leiterplattenkern) mit beidseitigen (konventionellen) Leiterbahnen 48 angeordnet, an dem beidseitig Schichten aus Trägermaterial 20 angeordnet sind. In die Schichten aus Trägermaterial 20 sind jeweils Leiterbahnstrukturen 16 eingebettet. In dem Leiterplattenkern 28 ist eine (vorab hergestellte) Durchkontaktierung 29 vorgesehen, die die sich gegenüberliegenden (konventionellen) Leiterbahnstrukturen 48, die in Kontakt mit dem Leiterplattenkern 28 sind, elektrisch verbinden.

In Fig. 5 sind die Leiterbahnstrukturen 16 der Schichten mit dem Trägermaterial 20, die auf der jeweils dem Leiterplattenkern 28 abgewandten Seite angeordnet sind, über (nachträglich hergestellte und gefüllte) Durchkontaktierungen 30 miteinander (und gegebenenfalls mit den Leiterbahnen 48) leitend verbunden. An die Schichten mit dem Trägermaterial 20 schließen sich nach außen Folien 24 (analog Fig. 4) an, derart, dass die Schichten mit dem Trägermaterial 20 zwischen Leiterplattenkern 28 und jeweils einer Folie 24 angeordnet sind.

Die Ausführungsform gemäß Fig. 6 entspricht im Wesentlichen der Ausführungsform gemäß Fig. 5. Die Durchkontaktierungen 30, die die Leiterbahnstrukturen 16 der Schichten mit Trägermaterial 20 verbinden, die an verschiedenen Seiten des Leiterplattenkerns 28 angeordnet sind, sind jedoch nicht vorgesehen. Zusätzlich sind Durchkontaktierungen 31 in den Folien 24 vorgesehen, die die Leiterbahnstrukturen 16 mit Außenkontakten 32 und teilweise auch mit den (konventionellen) Leiterbahnstrukturen 48 verbinden. Auch die Durchkontaktierungen 31 werden vorzugsweise nachträglich durch Füllen entsprechender Kontaktlöcher hergestellt.

Die Leiterplatten gemäß Fig. 5 und 6 sind insgesamt nicht flexibel sondern starr ausgebildet.

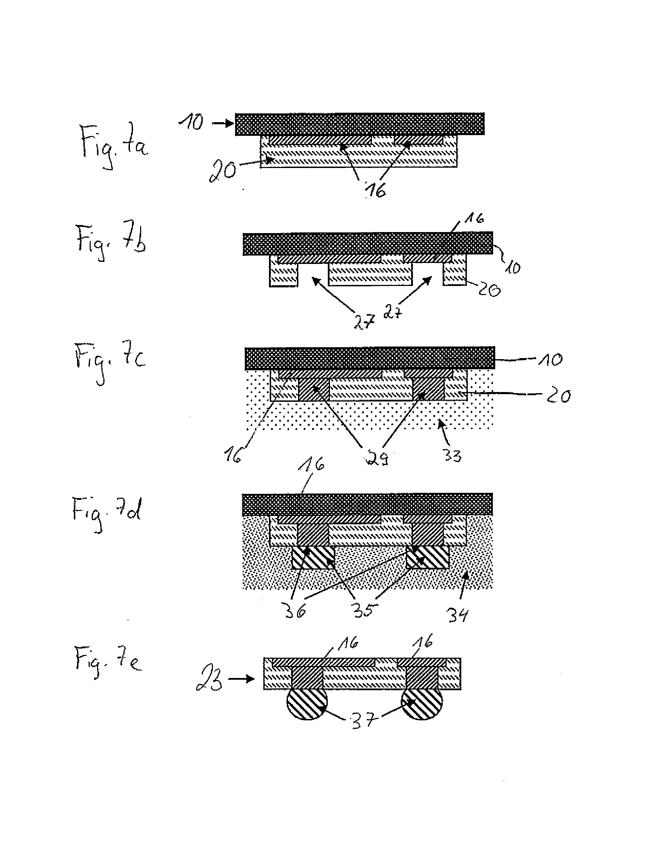

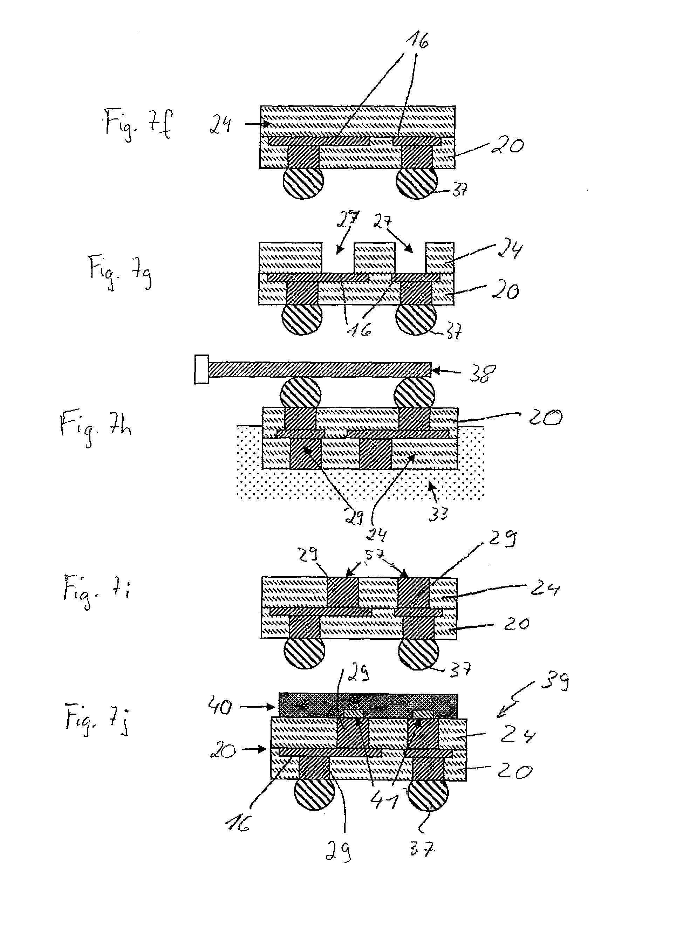

Die Fig. 7a bis 7i zeigen in schematischer Darstellung ein Verfahren zur Herstellung einer fünften Ausführungsform einer Leiterplatte, konkret eines so genannte "ball-grid array" (Kugelgitteranordnung; BGA) für das "chip packaging". Fig. 7j zeigt das fertige "BGA package" inklusive Mikrochip.

Zunächst wird hierzu in der bereits beschriebenen Art und Weise auf die Strukturelektrode 10 die Leiterbahnstruktur 16 aufgebracht. Die Leiterbahnstruktur 16 wird wiederum in ein Trägermaterial 20 eingebettet (siehe Fig. 7a).

Gemäß Fig. 7b werden danach Kontaktlöcher 27 in dem Trägermaterial 20 vorgesehen, beispielsweise durch Laserbohren.

Gemäß Fig. 7c werden die Kontaktlöcher 27 in Kontakt mit einem Elektrolytbad 33 gebracht und werden dadurch mit Metall, insbesondere Kupfer befüllt und bilden somit eine Durchkontaktierung 29, die die Leiterbahnstruktur 16 kontaktieren.

Die Durchkontaktierungen 29 werden dann in Kontakt mit einem zweiten Elektrolytbad 34 gebracht, so dass ein Lot 35 (beispielsweise Zinn-Silber oder Zinn-Silber-Kupfer) auf den nach außen weisenden Durchkontaktierungsflächen 36 sich abscheidet (siehe Fig. 7d).

Anschließend wird das Trägermaterial 20 mit der Leiterbahnstruktur 16, den Durchkontaktierungen 29 sowie dem Lot 35 von der Strukturelektrode 10 abgezogen. Durch Aufschmelzen entstehen die in Fig. 7e skizzierten Lotbälle 37.

Gemäß Fig. 7f wird auf das Trägermaterial 20 bzw. die in dieses eingebettete Leiterbahnstruktur 16 eine Folie 24 (Polyimidfilm) aufgebracht. In diese Folie 24 werden weitere Kontaktlöcher 27 eingebracht, die zumindest teilweise durch die Leiterbahnstruktur 16 umrandet werden (siehe Fig. 7g).

Die gemäß Fig. 7g hergestellten Kontaktlöcher 27 werden analog Fig. 7c elektrolytisch mit einem Metall (beispielsweise Kupfer, oder alternativ auch mit mehreren Metallschichten, wie Cu-Ni-Au) gefüllt. Dazu wird ein Elektrolytbad 33 (bzw. nacheinander mehrere verschiedene Elektrolytbäder) bereitgestellt. Zur Bereitstellung des für die Elektrolyse notwendigen Stromes ist ein elektrischer Anschluss 38 in Fig. 7h schematisch dargestellt.

Die in Fig. 7i gekennzeichnete Oberfläche 57 der Druckkontaktierungen 29 kann beispielsweise als Bondfläche genutzt oder auch galvanisch ebenfalls mit Lot versehen werden.

Fig. 7jzeigt schematisch das fertige BGA-Substrat 39 mit Mikrochip 40 und dessen Mikrochipkontakten 41. Die Mikrochipkontakte 41 erlauben einen Anschluss der Durchkontaktierungen 29 in der Folie 24. Diese sind wiederum über die Leiterbahnstruktur 16 und die Durchkontaktierungen 29 im Trägermaterial 20 mit den Lotbällen 37 verbunden. Der Mikrochip 40 ist in Flip-Chip-Technik ("Wende-MontageTechnik") montiert.

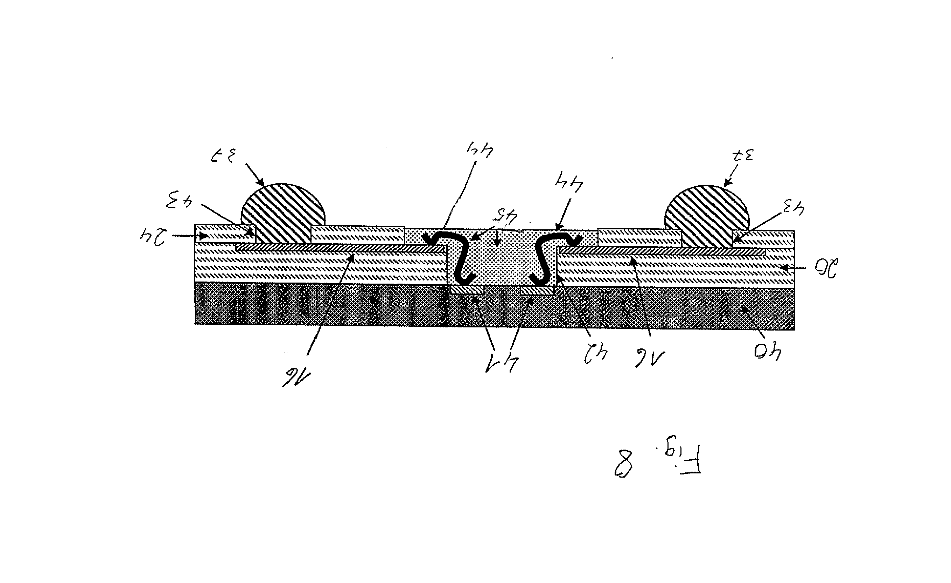

Fig. 8 zeigt in schematischer Darstellung eine weitere Ausführungsform einer Leiterplatte und ihrer Verwendung im Chip Packaging. In dem vorzugsweise als Folie vorliegenden Trägermaterial 20 ist eine Leiterbahnstruktur 16 eingebettet. Außerdem weist das Trägermaterial 20 eine (zentrale) Ausnehmung 42 auf.

Auf der einen (unteren) Seite des Trägermaterials 20 ist eine isolierende Abdeckung (beispielsweise eine Folie 24) mit Kontaktöffnungen 43 vorgesehen. Auf der anderen (oberen) Seite des Trägermaterials 20 ist ein Mikrochip 40 angeordnet. Mikrochipkontakte 41 sind über elektrische Verbindungen (Bond-Drähte) 44 mit der Leiterbahnstruktur 16 verbunden.

Die (zentrale) Ausnehmung 42 ist mit einem isolierenden Material 45 vergossen. Die Leiterbahnstruktur 16 ist in den Bereichen der Kontaktöffnungen 43 der Folie 24 (allgemein der isolierenden Schicht) mit Lotbällen 37 zur Außenkontaktierung versehen. Die Leiterplatten-Ausführung gemäß Fig. 8 kann in dieser Weise also als Window-CSP-Substrat für das Chip-Packaging zum Einsatz kommen.

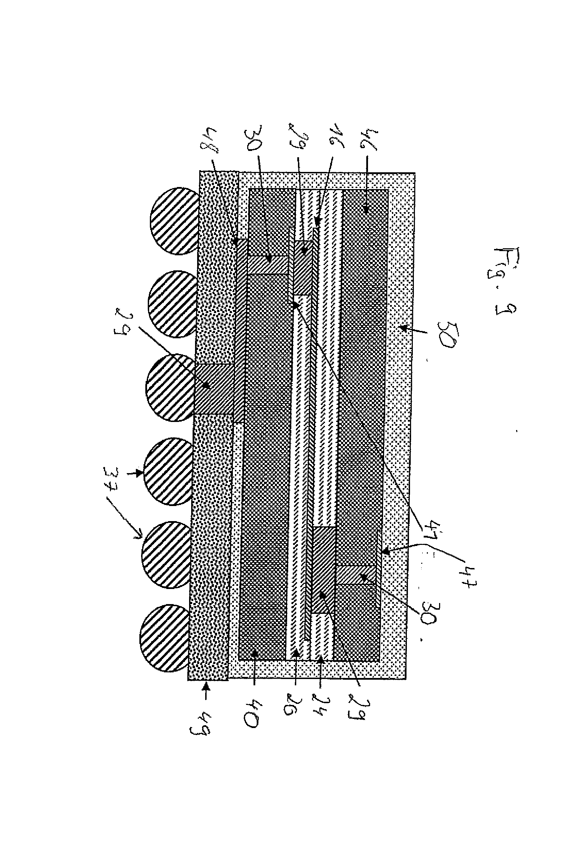

Fig. 9 zeigt die Verwendung des vorzugsweise als Folie vorliegenden Trägermaterials 20 mit der eingebetteten Leiterbahnstruktur 16 als ein Interposer für ein Multichip-Package. Auf der einen (unteren) Seite des Trägermaterials 20 ist ein erster Mikrochip 40 angeordnet, der an seiner dem Trägermaterial 20 zugewandten Seite einen Mikrochipkontakt 41 aufweist. Der Mikrochipkontakt 41 ist in elektrischer Verbindung mit einer Durchkontaktierung 29, die in dem Trägermaterial 20 ausgebildet ist.

Auf der anderen (oberen) Seite des Trägermaterials 20 ist eine isolierende Abdeckung (Folie) 24 angeordnet, die ebenfalls eine Durchkontaktierung 29 aufweist. Die Durchkontaktierung 29 der isolierenden Abdeckung 24 ist in elektrischem Kontakt mit der Leiterbahnstruktur 16 des Trägermaterials 20. Außerdem ist die Durchkontaktierung 29 der isolierenden Abdeckung 24 in elektrischem Kontakt mit einer Durchkontaktierung 30 eines zweiten Mikrochips 46. Die isolierende Abdeckung 24 ist zwischen zweiten Mikrochip 46 und Trägermaterial 20 angeordnet. Die Durchkontaktierung 30 des zweiten Mikrochips 46 ist vorzugsweise als Through-Silicon-Via ausgebildet. Außerdem ist die Durchkontaktierung 30 des zweiten Mikrochips 46 in elektrischer Verbindung mit einem Mikrochipkontakt 47 des zweiten Mikrochips 46. Der Mikrochipkontakt 47 ist auf der der isolierenden Abdeckung 24 abgewandten Seite des zweiten Mikrochips 46 angeordnet.

Über die Durchkontaktierung 30 des zweiten Mikrochips 46, die Durchkontaktierung 29 der isolierenden Abdeckung 24, die Leiterbahnstruktur 16 und die Durchkontaktierung 29 des Trägermaterials 20 ist somit der Mikrochipkontakt 47 des zweiten Mikrochips 46 mit dem Mikrochipkontakt 41 des ersten Mikrochips 40 verbunden.

Der Mikrochipkontakt 41 des ersten Mikrochips 40 ist weiterhin mit einer Durchkontaktierung 30 innerhalb des ersten Mikrochips 40 verbunden, die ebenfalls bevorzugt als Through-Silicon-Via ausgebildet ist. Die Durchkontaktierung 30 im ersten Mikrochip ist wiederum mit einer (konventionellen) Leiterbahnstruktur 48 elektrisch verbunden. Die Leiterbahnstruktur 48 ist an der Seite des ersten Mikrochips 40 angeordnet, die dem Trägermaterial 20 abgewandt ist. Die Leiterbahnstruktur 48 kann Bestandteil einer (konventionellen) Leiterplatte 49 sein, die auf der Seite des ersten Chips 40 angeordnet ist, die dem Trägermaterial 20 abgewandt ist.

Die Leiterplatte 49 weist eine Durchkontaktierung 29 auf, sowie Lotbälle 37. Die Lotbälle 37 sind auf der Seite der Leiterplatte 49 vorgesehen, die dem ersten Mikrochip 40 abgewandt ist.

Die Mikrochips 40, 46, das Trägermaterial 20 sowie die isolierende Abdeckung 24 sind vorzugsweise in einer isolierenden Verkapslung 50 untergebracht.

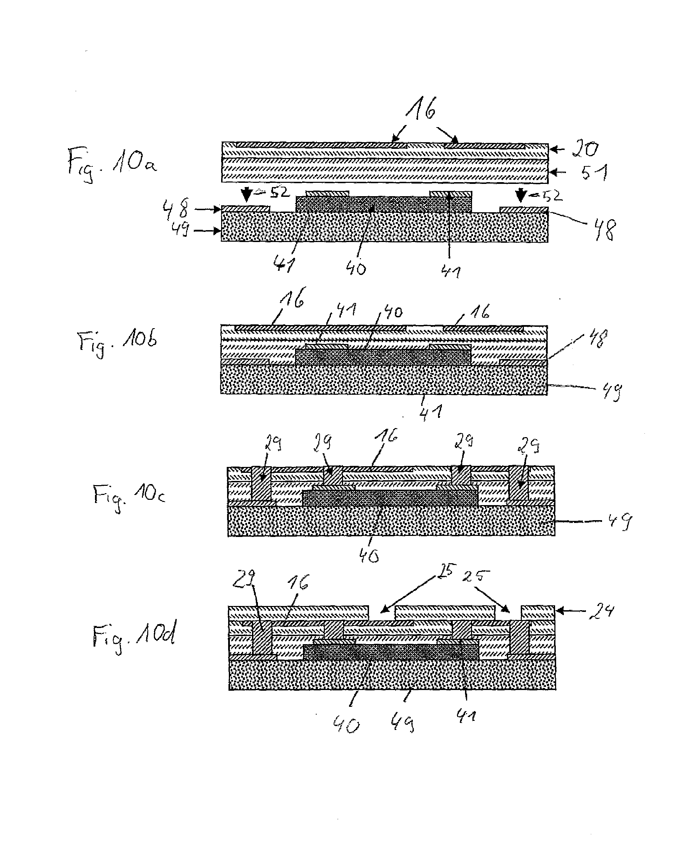

Fig. 10a zeigt das vorzugsweise als FR4-Folie vorliegende Trägermaterial 20 mit eingebetteter Leiterbahnstruktur 16 auf der einen (oberen) Seite und einer gegenüber angeordneten zusätzlichen Beschichtung 51 (Epoxidbeschichtung). Das Trägermaterial 20 mit eingebetteter Leiterbahnstruktur 16 und die Beschichtung 51 dienen als Kontaktierungslager für die Einbettung eines Mikrochips 40.

Der Mikrochip 40 ist auf einer (konventionellen) Leiterplatte 49 mit Leiterbahnstrukturen 48 angeordnet und weist auf seiner der Leiterplatte 49 abgewandten Seite Mikrochipkontakte 41 auf.

Durch eine Bewegung des Trägermaterials 20 mit Beschichtung 51 gemäß den Pfeilen 52 in Richtung der Seite des Mikrochips 40, die der Leiterplatte 49 abgewandt ist, wird der Mikrochip 40 z.B unter Aufwendung von Druck und Wärme mit der Beschichtung 51 und über diese mit dem Trägermaterial 20 verbunden. Dieser Zustand ist in Fig. 10b gezeigt.

Gemäß Fig. 10c werden dann Durchkontaktierungen 29 vorgesehen, die die Leiterbahnstruktur 16 des Trägermaterials 20 mit den Mikrochipkontakten 41 und den Leiterbahnstrukturen 48 der Leiterplatte 49 verbinden. Die Durchkontaktierungen 29 können nachträglich hergestellt sein und als gefüllte oder leitfähig ausgekleidete Kontaktlöcher vorliegen.

Zuletzt wird gemäß Fig. 10d auf der Seite des Trägermaterials 20, in der die Leiterbahnstruktur 16 eingebettet ist, eine Folie 24 mit Folienöffnungen 25 für eine Kontaktierung angeordnet.

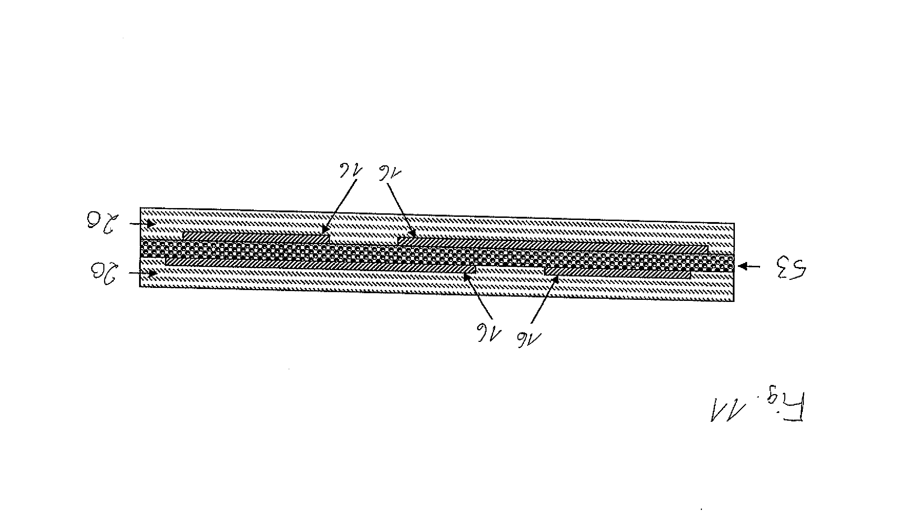

Fig. 11 zeigt schematisch die Anwendung von zwei vorzugsweise als Folien vorliegenden Trägermaterialien 20 mit jeweils einer eingebetteten Leiterbahnstruktur 16. Die Leiterbahnstrukturen 16 der Trägermaterialien 20 sind jeweils auf der dem anderen Trägermaterial 20 zugewandten Seite der Trägermaterialien angeordnet. Zwischen den Trägermaterialien 20 befindet sich eine Schicht 53. Die Schicht 53 weist vorzugsweise eine vergleichsweise hohe Dielektrizitätskonstante auf und ist insbesondere durch einen Kompositschlicker gemäß DE 10 2009 052 131 gebildet. Durch eine derartige Anordnung wird in den Bereichen, in denen sich die Leiterbahnstrukturen 16 gegenüberliegen, ein Kondensator gebildet.

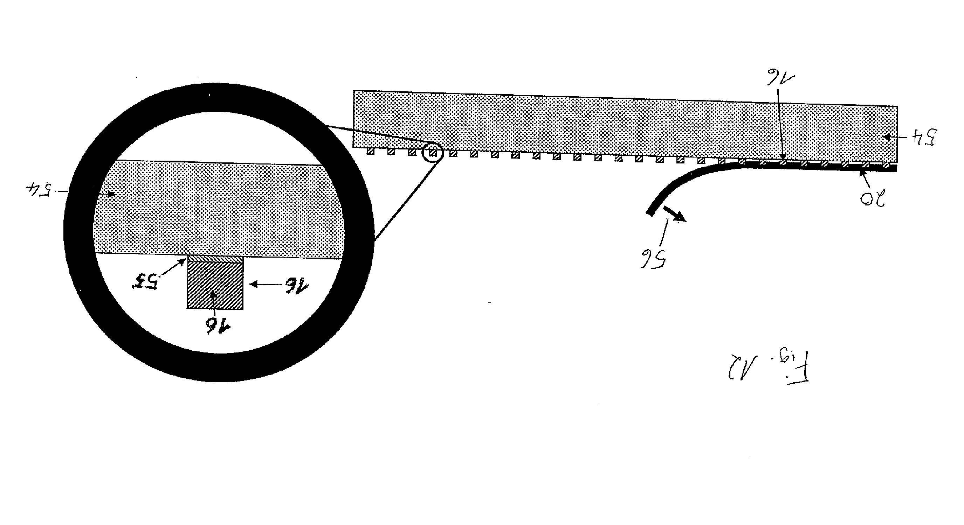

Fig. 12 zeigt schematisch eine Transferfolie zum Aufbringen einer Leiterbahnstruktur.

Das Trägermaterial 20 mit den Leiterbahnstrukturen 16 liegt als Folie vor und dient als Transfersubstrat. Das Trägermaterial 20 bzw. dessen Leiterbahnstrukturen 16 wird/werden über eine Schicht 55 mit einem Zielsubstrat 54 in Verbindung gebracht. Das Zielsubstrat 54 kann beispielsweise ein Solarzelle oder das TCO (transparente leitfähige Oxidschicht) einer großflächigen Leuchtdiode sein. Handelt es sich bei dem Zielsubstrat um eine Solarzelle, so wird vorzugweise die Lichteinfallseite der Solarzelle mit den Leiterbahnstrukturen 16 in Verbindung gebracht.

Die Schicht 55 stellt vorzugsweise eine elektrische und/oder eine mechanische Verbindung zum Zielsubstrat 54 her. Nach der Herstellung der mechanischen Verbindung der Leiterbahnstrukturen 16 zum Zielsubstrat 54 wird das als Transfersubstrat dienende Trägermaterial 20 entfernt, beispielsweise durch Abziehen, was durch den Pfeil 56 veranschaulicht ist.

Unter einer "Leiterbahnstruktur" kann entweder eine zusammenhängende Struktur verstanden werden, oder eine Struktur, die aus verschiedenen, voneinander getrennten Leiterbahnabschnitten besteht.

An dieser Stelle sei darauf hingewiesen, dass alle oben beschriebenen Teile für sich allein gesehen und in jeder Kombination, insbesondere die in den Zeichnungen dargestellten Details, als erfindungswesentliche beansprucht werden. Abänderungen hiervon sind dem Fachmann geläufig.

### Bezugszeichenliste

- 10: Strukturelektrode
- 11: Grundkörper
- 12: Isolierungsschicht
- 13: Isolierungsschichtausnehmung
- 14: Antihaftbeschichtung
- 15: Grundkörperoberfläche
- 16: Leiterbahnstruktur
- 17: Elektrolytbad
- 18: Gegenelektrode
- 19: Spannung
- 20: Trägermaterial
- 21: Trägermaterialfolie
- 22: Trägermaterialfolienbeschichtung
- 23: Leiterplatte
- 24: Isolierende Abdeckung (Folie)
- 25: Folienausnehmung
- 26: Leitermaterial
- 27: Kontaktloch
- 28: Leiterplattenkern
- 29: Durchkontaktierung
- 30: Durchkontaktierung
- 31: Durchkontaktierung
- 32: Außenkontakt
- 33: Elektrolytbad
- 34: zweites Elektrolytbad
- 35: Lot
- 36: Durchkontaktierungsfläche
- 37: Lotball
- 38: elektrischer Anschluss
- 39: BGA-Substrat
- 40: Mikrochip
- 41: Mikrochipkontakt
- 42: Ausnehmung
- 43: Kontaktöffnung
- 44: elektrische Verbindung
- 45: isolierendes Material
- 46: zweiter Mikrochip
- 47: Mikrochipkontakt des zweiten Mikrochips
- 48: Leiterbahnstruktur
- 49: Leiterplatte
- 50: isolierende Verkapselung
- 51: Beschichtung
- 52: Pfeil
- 53: Schicht
- 54: Zielsubstrat
- 55: Schicht
- 56: Pfeil
- 57: Oberfläche

## Patentansprüche

1. Verfahren zur Herstellung einer metallischen Leiterbahnstruktur (16), umfassend die Schritte:
a) Bereitstellung einer Steuerelektrode (10), die metallische und/oder halbleitende, leitfähige Bereiche der vorgegebenen Struktur mit gegenüber den übrigen Bereichen erhöhter Leitfähigkeit hat;
b) Kontaktieren der Steuerelektrode (10) mindestens bereichsweise mit einem Elektrolyten enthaltend mindestens ein Metall und Erzeugen eines Stromflusses über die Strukturelektrode (10) durch den Elektrolyten derart, dass unmittelbar oberhalb der metallischen und/oder halbleitenden, leitfähigen Bereiche die metallische Leiterbahnstruktur (16) gebildet wird;
c) Verbinden der Leiterbahnstruktur (16) mit einem Trägermaterial (20) zu einem Verbund;
d) Entfernen des Verbunds aus Leiterbahnstruktur (16) und Trägermaterial (20) von der Strukturelektrode (10).

2. Verfahren nach Anspruch 1,
**dadurch gekennzeichnet, dass**
zumindest die Oberfläche der Bereiche der Elektrode mit erhöhter Leitfähigkeit derart ausgebildet, insbesondere physikalisch und/oder chemisch behandelt wird, und/oder dass das die Leiterbahnstruktur (16) ausbildende Metall derart ausgewählt wird und/oder dass das Material der Strukturelektrode (10) derart ausgewählt wird, dass die strukturierte Metallschicht im Schritt d) von der Strukturelektrode (10) entfernt werden kann, jedoch im Schritt b) an der Strukturelektrode (10) verbleibt.

3. Verfahren nach Anspruch 1 oder 2,
**dadurch gekennzeichnet, dass**
die Strukturelektrode (10) zumindest teilweise aus Stahl, insbesondere Edelstahl gebildet ist und/oder zumindest bereichsweise poliert, insbesondere spiegelpoliert und/oder zumindest bereichsweise physikalisch oder chemisch beschichtet ist.

4. Verfahren nach einem der vorhergehenden Ansprüche,
**dadurch gekennzeichnet, dass**
eine Oberflächenrauheit der Strukturelektrode (10) kleiner als 5µm, vorzugsweise kleiner als 1µm, vorzugsweise kleiner als 500nm, weiter vorzugsweise kleiner als 200nm, noch weiter vorzugsweise kleiner als 100nm, noch weiter vorzugsweise kleiner als 50nm, weiter vorzugsweise kleiner als 10nm ist.

5. Verfahren nach einem der vorhergehenden Ansprüche,
**dadurch gekennzeichnet, dass**
die Strukturelektrode (10) eine, insbesondere strukturierte, elektrisch isolierende Isolierungsschicht (12) umfasst.

6. Verfahren nach einem der vorhergehenden Ansprüche, insbesondere nach Anspruch 5,
**dadurch gekennzeichnet, dass**
eine Schichtdicke der Leiterbahnstruktur (16) größer ist als eine Isolierungsschichtdicke der Isolierungsschicht (12), insbesondere mindestens 1,2mal, vorzugsweise mindestens 1,5mal, weiter vorzugsweise mindestens 2mal so groß, mindestens 5mal so groß oder mindestens 10mal so groß ist.

7. Verfahren nach einem der vorhergehenden Ansprüche,
**dadurch gekennzeichnet, dass**
das Trägermaterial (20) in festem oder flüssigem Zustand, insbesondere in einem Rolle-zu-Rolle-Verfahren, auf die Strukturelektrode (10) bzw. die strukturierte Metallschicht aufgebracht wird.

8. Verfahren nach einem der vorhergehenden Ansprüche,
**dadurch gekennzeichnet, dass**
die strukturierte Metallschicht nach dem Transfer auf das erste Trägermaterial (20) von diesem auf ein zweites Trägermaterial transferiert wird.

9. Strukturelektrode (10) insbesondere für das Verfahren nach einem der Ansprüche 1 bis 8, zur Herstellung einer metallischen Leiterbahnstruktur (16), die metallische und/oder halbleitende, leitfähige Bereiche einer vorgegebenen Struktur mit gegenüber den übrigen Bereichen erhöhter Leitfähigkeit hat,
**dadurch gekennzeichnet, dass**
eine Oberfläche der Strukturelektrode (10) derart physikalisch und/oder chemisch behandelt ist, vorzugsweise poliert, weiter vorzugsweise spiegelpoliert, alternativ vorzugsweise chemisch oder physikalisch beschichtet ist, dass eine auf die Strukturelektrode (10) durch Galvanisieren abgeschiedene, strukturierte Metallschicht im Ganzen von der Strukturelektrode (10) entfernt werden kann.

10. Strukturelektrode (10) nach Anspruch 9,
**dadurch gekennzeichnet, dass**
die Strukturelektrode (10) zumindest teilweise aus Stahl, insbesondere Edelstahl gebildet ist.

11. Strukturelektrode (10) nach Anspruch 9 oder 10,
**dadurch gekennzeichnet, dass**
eine Oberflächenrauheit der Strukturelektrode (10) kleiner als 5µm, vorzugsweise kleiner als 1µm, vorzugsweise kleiner als 500nm, weiter vorzugsweise kleiner als 200nm, noch weiter vorzugsweise kleiner als 100nm, noch weiter vorzugsweise kleiner als 50nm, weiter vorzugsweise kleiner als 10nm ist.

12. Strukturelektrode nach einem der Ansprüche 9 bis 11,
**dadurch gekennzeichnet, dass**
die Strukturelektrode (10) eine, insbesondere strukturierte, elektrisch isolierende Isolierungsschicht (12) umfasst.

13. Einheit aus einer Strukturelektrode (10), insbesondere nach einem der Ansprüche 9 bis 12, vorzugsweise für das Verfahren nach einem der Ansprüche 1 bis 8, und einem Elektrolyten mit mindestens einem Metall, wobei eine Oberfläche der Strukturelektrode (10) und die Zusammensetzung des Elektrolyten derart aufeinander abgestimmt sind, dass bei einem Abscheiden des Elektrolyten als strukturierte Metallschicht auf die Oberfläche der Strukturelektrode (10), die strukturierte Metallschicht im Ganzen von der Strukturelektrode (10) entfernt werden kann.

14. Verwendung der metallischen Leiterbahnstruktur (16), hergestellt nach dem Verfahren nach einem der Ansprüche 1 bis 8 und/oder mit der Strukturelektrode nach einem der Ansprüche 9 bis 12 und/oder mit der Einheit nach Anspruch 13 zur Verbindung von Kontaktpunkten oder -bereichen von elektrischen oder elektronischen Bauteilen miteinander oder mit den Kontaktpunkten anderer Bauteile und/oder als elektrische oder elektronische Bauteile und/oder Bestandteile davon, insbesondere als Leiterplatten oder Bestandteile von Leiterplatten, als Substrat oder Hilfssubstrat für die Verkapselung bzw. Kontaktierung von elektronischen Bauteilen, wie beispielsweise Mikrochips, als passives elektronisches Bauteil, wie eine Antenne, Spule, Widerstand oder Kondensatorplatte oder als Kombination derartiger Bauteile, als Zwischenträger für den Transfer von Leiterbahnen auf andere Werkstücke oder als Kontaktierungslage für Solarzellen, großflächige Leuchtsysteme oder ähnliche Bauteile.
